# EUROPÄISCHE PATENTSCHRIFT

(11) **EP 2 014 377 B1**
(45) Veröffentlichungstag und Bekanntmachung des Hinweises auf die Patenterteilung: **31.03.2010**
(21) Anmeldenummer: 07013720.3
(22) Anmeldetag: 12.07.2007
(51) Int. Cl.: B05C 13/02, C23C 14/50

(54) **Halterung für Turbinenschaufeln**
Mounting for turbine blades
Fixation pour palettes de turbines

(43) Veröffentlichungstag der Anmeldung: 14.01.2009
(73) Patentinhaber: SIEMENS AKTIENGESELLSCHAFT, 80333 München (DE)
(72) Erfinder: Berndt, Thomas, 12524 Berlin (DE)

(56) Entgegenhaltungen:
- EP-A- 0 863 226
- EP-B- 0 975 435
- WO-A-2004/055227
- US-A- 2 645 611
- US-A- 3 783 007
- US-A- 4 271 005
- US-A- 5 264 245

## Beschreibung

Die Erfindung betrifft eine Halterung für wenigstens zwei Turbinenschaufeln zur Verwendung in einer Beschichtungsvorrichtung, die für jede Turbinenschaufel eine Einspanneinrichtung zur Fixierung von Schaufelfuß und Schaufelblatt aufweist, wobei wenigstens zwei Einspanneinrichtungen übereinander an einem Gestänge der Halterung angebracht sind.

Turbinenschaufeln werden mit Beschichtungen versehen, um ihre Wärme- und Korrosionsbeständigkeit zu erhöhen. Dazu werden beispielsweise eine MCrAlY-Haftvermittlerschicht und eine darauf liegende Keramikschicht durch PVD (Physical Vapour Deposition) aufgetragen. Im Stand der Technik sind Halterungen bekannt, um mehrere Turbinenschaufeln gleichzeitig zu fixieren, die dann als Ganzes in einer Beschichtungskammer angeordnet werden können. Der Einsatz derartiger Halterungen ermöglicht es, mehrere Turbinenschaufeln in einem Durchgang zu beschichten.

Eine Halterung der eingangs genannten Art ist beispielsweise in der EP 0 975 435 B1 beschrieben. Diese Halterung umfasst ein zentrales Element, an dem in mehreren Ebenen übereinander Einspanneinrichtungen für Turbinenschaufeln ausgebildet sind. Dabei sind die Einspanneinrichtungen ausgelegt, jeweils eine Turbinenschaufel an ihrem Schaufelfuß und an ihrem Schaufelblatt zu fixieren. Weiterhin sind jeweils zwei Einspanneinrichtungen in übereinander liegenden Ebenen spiegelbildlich zueinander angeordnet.

Beim Einsatz der bekannten Halterung in einer Beschichtungsvorrichtung kann es schwierig sein, ein gleichmäßiges Auftragen der Beschichtung auf alle Bereiche der Turbinenschaufeln sicher zu stellen. So wird das von der Beschichtungsvorrichtung abgegebene Beschichtungsmaterial aufgrund der unterschiedlichen Orientierung der Turbinenschaufeln ungleichmäßig auf dieser abgeschieden.

Es ist daher Aufgabe der vorliegenden Erfindung, eine Halterung der eingangs genannten Art anzugeben, mit der es möglich ist, mehrere Turbinenschaufeln auf einfache Weise gleichmäßig zu beschichten.

Diese Aufgabe wird erfindungsgemäß ddurch die Merkmale von Anspruch 1 gelöst.

Durch die gleiche räumliche Ausrichtung zweier Einspanneinrichtungen fluchtend übereinander sind auch die darin fixierten Turbinenschaufeln räumlich gleich ausgerichtet, so dass auf einfache Weise sichergestellt ist, dass die Turbinenschaufeln gleichmäßig beschichtet werden, wenn die Halterung in einer Beschichtungsvorrichtung verwendet wird. So besteht nicht die Gefahr, dass unterschiedliche Bereiche der einzelnen Turbinenschaufeln mit zu viel oder zu wenig Beschichtungsmaterial versehen werden.

Gemäß einer Ausführungsform der Erfindung ist vorgesehen, dass die Einspanneinrichtungen mit jeweils einem Maskierungselement versehen sind, welches den Schaufelfuß im eingespannten Zustand umschließt. Dieses Maskierungselement kann beispielsweise kastenförmig ausgebildet sein und offene Ober- und Unterseiten aufweisen. Die Turbinenschaufel kann dann mit ihrem Schaufelfuß durch die offene Oberseite hindurch geführt werden. Anschließend wird die Unterseite des Maskierungselementes verschlossen, so dass der Schaufelfuß der Turbinenschaufel vollständig von dem Maskierungselement umgeben ist. Vorteile dieser Ausführungsform sind, dass auf einfache Weise verhindert werden kann, dass Beschichtungsmaterial auf die Oberfläche des Schaufelfußes gelangt.

Es ist ebenfalls möglich, dass die Einspanneinrichtungen jeweils ein Abschattungselement für die Abströmkante des Schaufelblattes aufweisen. Auf diese Weise wird sichergestellt, dass auf die Abströmkante des Schaufelblattes während des Beschichtungsvorganges kein Beschichtungsmaterial auftrifft.

In Weiterbildung der Erfindung ist vorgesehen, dass das Gestänge ein zentrales Element aufweist, über das die Halterung als Ganzes drehbar ist. Diese Ausbildung ermöglicht es, die Beschichtungsvorrichtung während des Beschichtungsvorgangs so zu drehen, dass die eingespannten Turbinenschaufeln gleichmäßig von allen Seiten beschichtet werden.

Weitere vorteilhafte Ausführungsformen sind in den Unteransprüchen angegeben.

Die Erfindung wird im Folgenden anhand eines Ausführungsbeispiels unter Bezugnahme auf die Zeichnungen detailliert beschrieben.

In den Zeichnungen zeigen:
- Figur 1: eine perspektivische Ansicht einer erfindungsgemäßen Halterung,

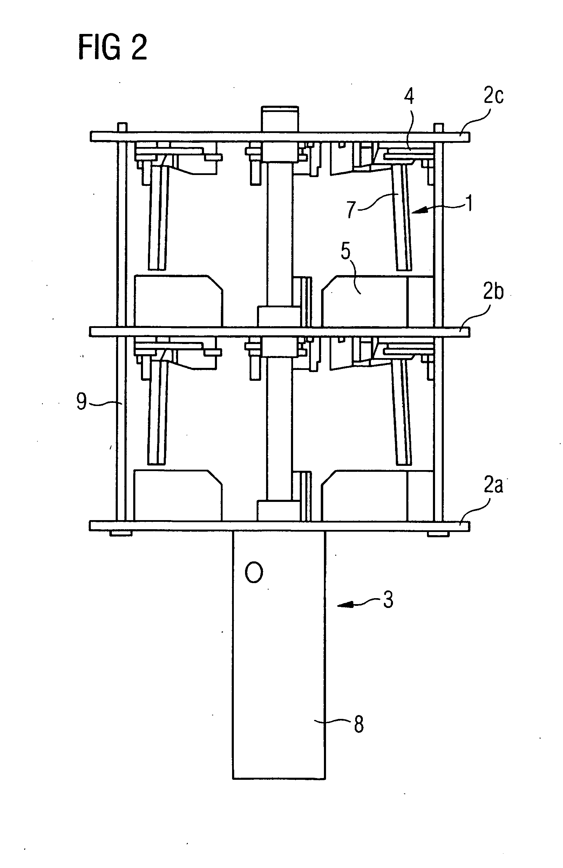

- Figur 2: eine seitliche Ansicht der Halterung der Figur 1,
- Figur 3: eine perspektivische Ansicht eines Teils der Halterung der Figur 1 in zerlegtem Zustand,
- Figur 4: eine seitliche Ansicht eines Teils der Halterung der Figur 1 in teilweise montiertem Zustand, und
- Figur 5: eine seitliche Ansicht der Halterung der Figur 1 im montierten Zustand ohne Versteifungsstangen.

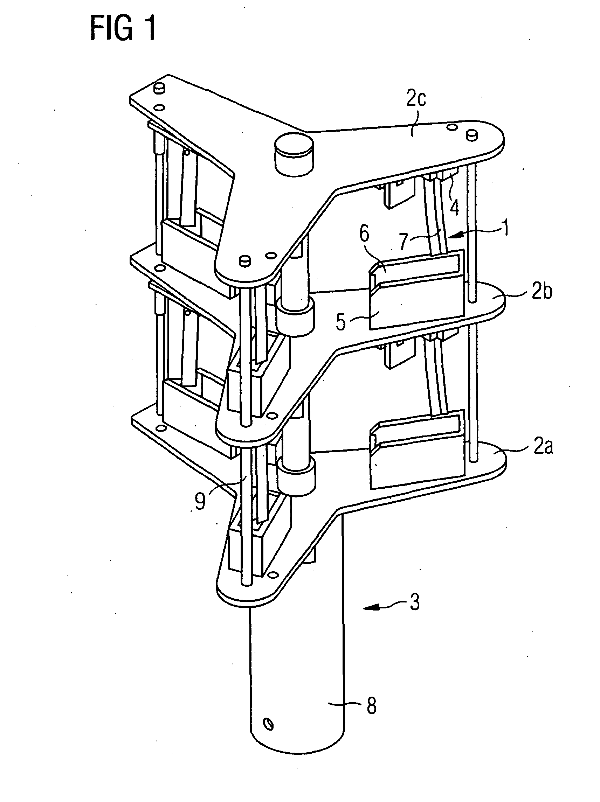

In der Figur 1 ist eine erfindungsgemäße Halterung für sechs Turbinenschaufeln in perspektivischer Ansicht gezeigt, die zur Verwendung in einer Beschichtungsvorrichtung ausgelegt ist. Die Halterung weist sechs Einspanneinrichtungen 1 auf, wobei jeweils drei Einspanneinrichtungen auf einer Ebene über sternförmig ausgebildete Halteelemente 2 an einem Gestänge 3 der Halterung angebracht sind. Jeweils zwei Einspanneinrichtungen 1 der verschiedenen Ebenen sind mit der gleichen Orientierung fluchtend übereinander angeordnet.

Die Einspanneinrichtungen 1 weisen jeweils ein unteres, in der Zeichnung nicht gezeigtes Spannelement zur Fixierung eines Schaufelfußes und ein oberes Spannelement 4 zur Fixierung eines Schaufelblatts einer Turbinenschaufel auf, wobei diese jeweils an zwei übereinander angeordneten Halteelementen 2 befestigt sind. Weiterhin sind die Einspanneinrichtungen 1 jeweils mit einem kastenförmig ausgebildeten Maskierungselement 5 für den Schaufelfuß der Turbinenschaufel versehen. Das Maskierungselement 5 weist eine offene Oberseite 6 und eine offene Unterseite auf, wobei die Oberseite 6 ausgebildet ist, um ein durchgeführtes Schaufelblatt einzufassen. An der offenen Unterseite ist eine in der Zeichnung nicht gezeigte Verschlussklappe anbringbar, die das Maskierungselement 5 nach dem Einsetzen der Turbinenschaufel verschließt, so dass der Schaufelfuß der Turbinenschaufel vollständig von dem Maskierungselement 5 umschlossen ist.

An den oberen Spannelementen 4 ist jeweils zusätzlich lösbar ein Abschattungselement 7 befestigt, das die Abströmkante des Schaufelblatts einer in der Spanneinrichtung 1 fixierten Turbinenschaufel überdeckt.

Das Gestänge 3 der Halterung wird von einem säulenförmig ausgebildeten zentralen Element 8, den Halteelementen 2 sowie von Versteifungsstangen 9 gebildet, die die übereinander liegenden Halteelemente 2 miteinander verbinden. Das zentrale Element 8 des Gestänges 3 ist so ausgebildet, dass es beispielsweise nach Verbindung mit einem geeigneten Motor automatisch um seine eigene Achse gedreht werden kann. Das gesamte Gestänge 3 ist zerlegbar ausgebildet.

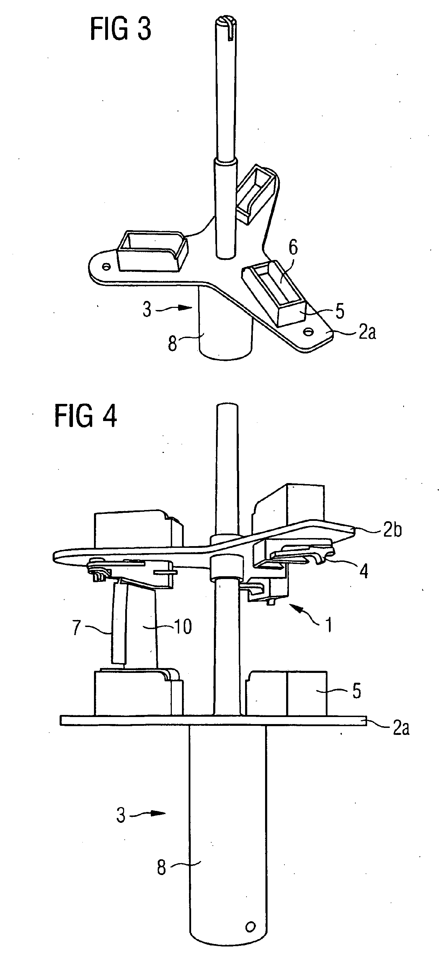

Um Turbinenschaufeln in der Halterung zu befestigen, werden die Versteifungsstangen 9 und die beiden oberen Halteelemente 2b, 2c entfernt. Dieser Zustand der Halterung ist in der Figur 3 gezeigt. Anschließend werden drei Turbinenschaufeln 10 mit ihren jeweiligen Schaufelfüßen durch die offenen Oberseiten in die der Maskierungselemente 5 des unteren Halteelements 2a eingesetzt und mit Hilfe der unteren Spannelemente der Einspanneinrichtungen 1 fixiert. Dann werden die Unterseiten der Maskierungselemente 5 mit Verschlusskappen geschlossen.

In einem weiteren Schritt wird das mittlere Halteelement 2b auf das zentrale Element 8 der Halterung aufgeschoben, bis die an der Unterseite des Halteelements 2b ausgebildeten oberen Spannelemente 4 die Spitzen der Schaufelblätter der Turbinenschaufel 10 einfassen. Dabei überdecken die Abschaltungselemente 7 die Abströmkanten der Schaufelblätter. Die Schaufelblätter werden mit Hilfe der oberen Spannelemente 4 fixiert. In der Figur 4 ist die Halterung in diesem Zustand gezeigt, wobei jedoch nur eine Turbinenschaufel 10 fixiert ist.

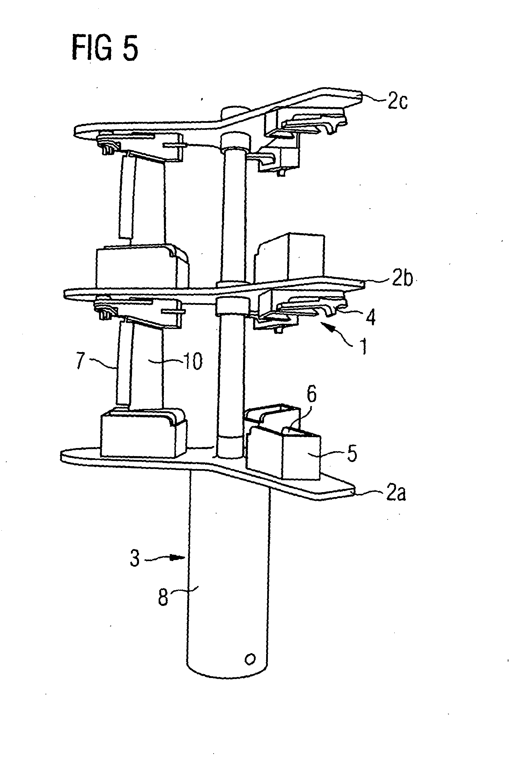

Danach werden in der oben beschriebenen Weise drei weitere Turbinenschaufeln 10 zwischen den unteren und oberen Spannelementen des mittleren und des oberen Halteelements 2b, 2c fixiert. Die Figur 5 zeigt die Halterung mit einer eingesetzten Turbinenschaufel 10 mit allen drei Halteelementen 2a, 2b, 2c, jedoch ohne die Versteifungsstangen 9.

Zuletzt werden die Versteifungsstangen 9 in die Halterung wieder eingesetzt und verriegelt. In diesem Zustand kann die Halterung mit den Turbinenschaufel 10 in einer Beschichtungsvorrichtung eingesetzt werden.

Jeweils zwei übereinander am Gestänge 3 befestigte Spanneinrichtungen 1 weisen die gleiche räumliche Ausrichtung und Orientierung auf. Folglich haben auch zwei Turbinenschaufeln 10, die in diesen beiden Einspanneinrichtungen fixiert sind, dieselbe räumliche Ausrichtung. Wenn die Halterung als Ganzes dann in einer Beschichtungsvorrichtung angeordnet und während des Beschichtungsvorganges um das zentrale Element 8 gedreht wird, erfolgt eine gleichmäßige Beschichtung der in den Einspanneinrichtungen 1 fixierten Turbinenschaufeln 10.

## Patentansprüche

1. Halterung für wenigstens zwei Turbinenschaufeln (10) zur Verwendung in einer Beschichtungsvorrichtung, die für jede Turbinenschaufel (10) eine Einspanneinrichtung (1) zur Fixierung von Schaufelfuß und Schaufelblatt aufweist,
wobei wenigstens zwei Einspanneinrichtungen (1) übereinander an einem Gestänge (3) der Halterung angebracht sind,
**dadurch gekennzeichnet, dass**
die Einspanneinrichtungen (1) jeweils ein unteres Spannelement zur Fixierung eines Schaufelfußes und ein oberes Spannelement (4) zur Fixierung eines Schaufelblattes einer Turbinenschaufel aufweisen,
wobei diese jeweils an zwei übereinander an dem Gestänge (3) angebrachten Halteelementen (2) befestigt sind, und
wobei jeweils zwei übereinander angeordnete Einspanneinrichtungen (1) mit der gleichen Orientierung fluchtend übereinander angeordnet sind.

2. Halterung nach Anspruch 1,
**dadurch gekennzeichnet, dass**
die Einspanneinrichtungen (1) mit jeweils einem Maskierungselement (6) versehen sind, welches den Schaufelfuß im eingespannten Zustand umschließt.

3. Halterung nach einem der vorhergehenden Ansprüche,
**dadurch gekennzeichnet, dass**
die Einspanneinrichtungen (1) jeweils ein Abschattungselement (7) für die Abströmkante des Schaufelblatts aufweisen.

4. Halterung nach einem der vorhergehenden Ansprüche,
**dadurch gekennzeichnet, dass**
das Gestänge (3) ein zentrales Element (8) aufweist, über das die Halterung als Ganzes drehbar ist.

5. Halterung nach einem der vorhergehenden Ansprüche,
**dadurch gekennzeichnet, dass**
jeweils drei Einspanneinrichtungen (1) in zwei Ebenen übereinander insbesondere sternförmig am Gestänge (3) angebracht sind.

6. Halterung nach einem der vorhergehenden Ansprüche,
**dadurch gekennzeichnet, dass**
das Gestänge (3) zerlegbar ausgebildet ist.

## Claims

1. Mounting for at least two turbine blades (10) for use in a coating apparatus, which for each turbine blade (10) has a chucking device (1) for fixing the blade root and blade leaf, at least two chucking devices (1) being attached one above the other to a linkage (3) of the mounting, **characterized in that** the chucking devices (1) each have a lower tension element for fixing a blade root and an upper tension element (4) for fixing a blade leaf of a turbine blade, these being fastened in each case to two holding elements (2) attached one above the other to the linkage (3), and in each case two chucking devices (1) arranged one above the other being arranged in alignment one above the other with the same orientation.

2. Mounting according to Claim 1, **characterized in that** the chucking devices (1) are provided in each case with a masking element (6) which surrounds the blade root in the chucked state.

3. Mounting according to one of the preceding claims, **characterized in that** the chucking devices (1) have in each case a shading element (7) for the trailing edge of the blade leaf.

4. Mounting according to one of the preceding claims, **characterized in that** the linkage (3) has a central element (8), via which the mounting is rotatable as a whole.

5. Mounting according to one of the preceding claims, **characterized in that** in each case three chucking devices (1) are attached in two planes one above the other, in particular in the form of a star, to the linkage (3).

6. Mounting according to one of the preceding claims, **characterized in that** the linkage (3) is designed to be dismantlable.

## Revendications

1. Fixation pour au moins deux aubes ( 10 ) de turbine à utiliser dans un dispositif de revêtement, qui a, pour chaque aube ( 10 ) de turbine, un dispositif ( 1 ) de blocage pour immobiliser l'emplanture de l'aube et la lame de l'aube, dans lequel au moins deux dispositifs ( 1 ) de blocage sont mis l'un au-dessus de l'autre sur une tringlerie ( 3 ) de la fixation,
**caractérisée en ce que**
les dispositifs ( 1 ) de blocage ont respectivement un élément inférieur de blocage pour immobiliser une emplanture d'aube et un élément ( 4 ) supérieur de blocage pour immobiliser une lame d'aube d'une aube de turbine,
dans laquelle ceux-ci sont fixés respectivement à deux éléments ( 2 ) de maintien superposés sur la tringlerie ( 3 ), et
dans laquelle respectivement deux dispositifs ( 1 ) de blocage superposés sont superposés en alignement et en ayant la même orientation.

2. Fixation suivant la revendication 1,
**caractérisée en ce que**
les dispositifs ( 1 ) de blocage sont munis respectivement d'un élément ( 6 ) de masquage qui entoure l'emplanture de l'aube à l'état bloqué.

3. Fixation suivant l'une des revendications précédentes,
**caractérisée en ce que**
les dispositifs ( 1 ) de blocage ont respectivement un élément ( 7 ) de protection pour les bords de fuite de la lame de l'aube.

4. Fixation suivant l'une des revendications précédentes,
**caractérisée en ce que**
la tringlerie ( 3 ) a un élément ( 8 ) central par lequel la fixation peut tourner en son entier.

5. Fixation suivant l'unes des revendications précédentes,
**caractérisée en ce que**
respectivement trois dispositifs ( 1 ) de blocage sont mis sur la tringlerie ( 3 ) dans deux plans en étant superposés, notamment en étoile.

6. Fixation suivant l'une des revendications précédentes,
**caractérisée en ce que**
la tringlerie ( 3 ) peut être désassemblée.
